# EUROPEAN PATENT SPECIFICATION

(11) **EP 4 385 944 B1**
(45) Date of publication and mention of the grant of the patent: **01.07.2026**
(21) Application number: 22213368.8
(22) Date of filing: 14.12.2022
(51) Int. Cl.: B81B 7/00, B81C 1/00, B81C 3/00, H10N 69/00, H10W 72/90, H10W 80/00, H10W 90/00

(54) **A METHOD FOR BONDING AND INTERCONNECTING MICRO-ELECTRONIC COMPONENTS**
VERFAHREN ZUM VERBINDEN UND VERBINDEN VON MIKROELEKTRONISCHEN KOMPONENTEN
PROCÉDÉ DE LIAISON ET D'INTERCONNEXION DE COMPOSANTS MICROÉLECTRONIQUES

(43) Date of publication of application: 19.06.2024
(73) Proprietor: Imec VZW, 3001 Leuven (BE)
(72) Inventor: Derakhshandeh, Jaber, 3300 Tienen (BE); Beyne, Eric, 3001 Heverlee (BE)
(74) Representative: Patent Department IMEC

(56) References cited:
- WO-A2-2014/168665
- US-A1- 2021 265 253
- US-A1- 2021 343 654
- US-B2- 7 402 905

## Description

### Field of the Invention

The present invention is related to the bonding and interconnecting of micro-electronic components such as integrated circuit chips, interposer substrates and printed circuit boards.

### State of the art.

3D integration of microchips involves the bonding and interconnecting of multiple stacked chips, and/or the bonding and interconnecting of a chip to a larger carrier component such as an interposer or a printed circuit board (PCB). For microchips which include larger devices such as MEMS devices or superconducting quantum qubits, these larger devices are often produced on separate chips which are subsequently bonded to a carrier such as an interposer or PCB by microbump bonding. In cases where the spacing between the device and the carrier is of crucial importance, this approach is often unable to realize the required spacing because of the inadequate control of the bump thickness. Another problem is that the interconnect density attainable with microbump connections is limited.

Patent publication document US7402905 discloses a hermetic, gas filled or vacuum package device and method of making a vacuum package device. The device includes a device layer having one or more Micro Electro-Mechanical Systems (MEMS) devices. The device layer includes one or more electrical leads coupled to the one or more MEMS devices. The device also includes a first wafer having one or more silicon pins, wherein a first surface of the first wafer is bonded to a first surface of the device layer in such a manner that the one or more silicon pins are in electrical communication with the electrical leads. A second wafer, which may also have one or more silicon pins, is bonded to a second surface of the device layer. The first and second wafers are formed of borosilicate glass and the device layer is formed of silicon.

### Summary of the invention

The invention aims to provide a solution to the problems highlighted above. This aim is achieved by a method and by an assembly of micro-electronic components as disclosed in the appended claims. According to the invention, a first and second substrate are bonded to each other to form a 3D assembly of micro-electronic components. Both substrates comprise a plurality of first cavities open to the respective bonding surfaces and at least one substrate comprises a second cavity that is much larger than the first cavities in terms of its in-plane dimensions, and possibly also in terms of its depth. Prior to bonding, an electrically conductive layer is produced conformally on each substrate. Said layer is patterned in the large cavity or cavities and in said large cavity or cavities a micro-electronic device or a portion thereof is fabricated. Thereafter, the bonding surfaces are planarized, removing the conformal layer from said bonding surfaces, after which the substrates are bonded to form the assembly, wherein the first cavities of both substrates are brought into mutual contact to form an electrical connection. Possibly, the first cavities may be filled with a contact material such as copper or solder prior to the planarization step. Any device in the large cavities may be contacted through suitable connection means such as TSV connections or back end of line interconnect levels. The formation of the devices or device parts in pre-formed cavities enables an improved control of a number of device properties, such as the spacing between two capacitor plates. In addition, the interconnect through direct bonding of the bonding surfaces enables a higher interconnect density compared to microbump-based interconnects.

The invention is in particular related to a method for producing a stacked assembly of micro-electronic components, the method comprising the steps of:
- providing a first and second substrate, each substrate having a planar bonding surface, wherein :
   ∘ the first substrate and the second substrate both comprise a group of first cavities open to the respective bonding surfaces,
   ∘ the groups of first cavities are arranged in mutually matching patterns on the first and second substrate,
   ∘ at least one of the substrates comprises at least one second cavity open to the bonding surface of said substrate, wherein the second cavity has larger in-plane dimensions than the in-plane dimensions of the first cavities,
   ∘ at least one of the substrates comprises electrical conductors embedded in the substrate and available for contacting said electrical conductors at a bottom portion of the first cavities and/or the second cavity,
- producing a first and second layer formed of a first electrically conductive material on said respective bonding surfaces, said layers conformally covering said bonding surfaces and the sidewalls and bottom surfaces of the first cavities and of the second cavity,
- patterning the layer formed of the first conductive material in the second cavity and producing a micro-electronic device or a part thereof in said second cavity, wherein said device or part does not extend above the bonding surface of the substrate comprising the second cavity,
- by a planarization technique, removing the layers formed of the first electrically conductive material from the bonding surfaces while keeping said layers at least on the bottom and sidewalls of the first cavities,
- bonding and interconnecting the substrates, to thereby obtain said stacked assembly of components, wherein at least the sidewalls of the first cavities of the first substrate overlap corresponding sidewalls of the first cavities of the second substrate so that an electrical connection is established between said respective sidewalls, and wherein the device or device part in the second cavity is electrically connected to one or more other components of the stack.

According to an embodiment, the method further comprises the following steps applied to the two substrates :
- prior to applying said planarization technique, depositing a second electrically conductive material in the first cavities and on the bonding surface in between said first cavities,
- by applying said planarization technique, removing both the second and first conductive materials from the bonding surface, before performing the bonding step.

According to an embodiment, on at least one of the substrates, said second cavity and a plurality of the first cavities are together forming a common cavity, said plurality of the first cavities branching out from one or more sidewalls of the second cavity, wherein the layer of the first conductive material is maintained on said one or more sidewalls of the second cavity so that said layer forms an electrical connection between said plurality of the first cavities and the second cavity.

According to an embodiment, the electrical connection between the matching first cavities of the two substrates is established only by the layers of the first conductive material on the sidewalls and the bottom of said first cavities.

According to an embodiment, the first cavities have an elongate shape, wherein the first cavities of the first substrate overlap the first cavities of the second substrate in a crosswise fashion.

According to an embodiment, at least some of said number of conductors are through substrate via (TSV) connections.

According to an embodiment, at least some of said number of conductors are interconnect vias which are part of a back end of line type interconnect structure.

According to an embodiment, the depth of the second cavity is considerably larger than the depth of the first cavities.

According to an embodiment, the depth of the second cavity is the same as the depth of the first cavities.

According to an embodiment, said devices or parts thereof are superconducting qubits or parts thereof.

According to an embodiment, the first substrate comprises a number of said second cavities, each of said number comprising multiple elements of a superconducting qubit including one plate of a capacitor, wherein the second substrate comprises an equal number of said second cavities, each comprising another capacitor plate that is capacitively coupled to the plates in the first substrate after the bonding step.

The invention is also related to a stacked assembly of micro-electronic components, at least two of said components being bonded along a bonding interface, and comprising matching pluralities of interconnected first cavities open to the bonding interface, wherein said first cavities of the two components are interconnected at least by layers of a first electrically conductive material lining the sidewalls and bottom of said first cavities, and wherein at least one component further comprises a second cavity open to the bonding interface that has in-plane dimensions which are larger than the in-plane dimensions of the first cavities, and wherein said second cavity comprises a micro-electronic device or a part thereof that is electrically connected through a layer of the first conductive material present at least on a bottom area of the second cavity, to one or more other components of the stacked assembly.

According to an embodiment of the stacked assembly, said devices or parts thereof are superconducting qubits or parts thereof.

### Brief description of the figures

Figures 1a and 1b illustrate an assembly of components produced in accordance with an embodiment of the invention.
Figures 2a to 2h illustrate key method steps for producing the assembly shown in Figures 1a and 1b.
Figures 3a to 3d illustrate one method for producing a substrate comprising TSVs of different depths and one or more large cavities.
Figures 4a to 4c illustrate an alternative embodiment wherein the smaller cavities are formed in a dielectric bonding layer.
Figure 5 illustrates a number of alternatives for multiple features of the invention.
Figure 6 illustrates an embodiment wherein smaller cavities are branching out from a larger cavity in one of the substrates which are to be bonded.
Figures 7a to 7e illustrate key steps for producing the assembly shown in Figure 6.
Figure 8 illustrates an integrated circuit chip that is to be processed and bonded to another substrate, in accordance with an embodiment of the invention.
Figures 9a to 9e illustrate key steps of the method as applied to the integrated circuit chip shown in Figure 8.
Figure 10 illustrates an assembly of components wherein the large cavities are completely filled.

### Detailed description of the invention

In the following detailed description, all references to specific materials and dimensions are included by way of example only, and none of these citations are to be construed as limitations of the protection scope.

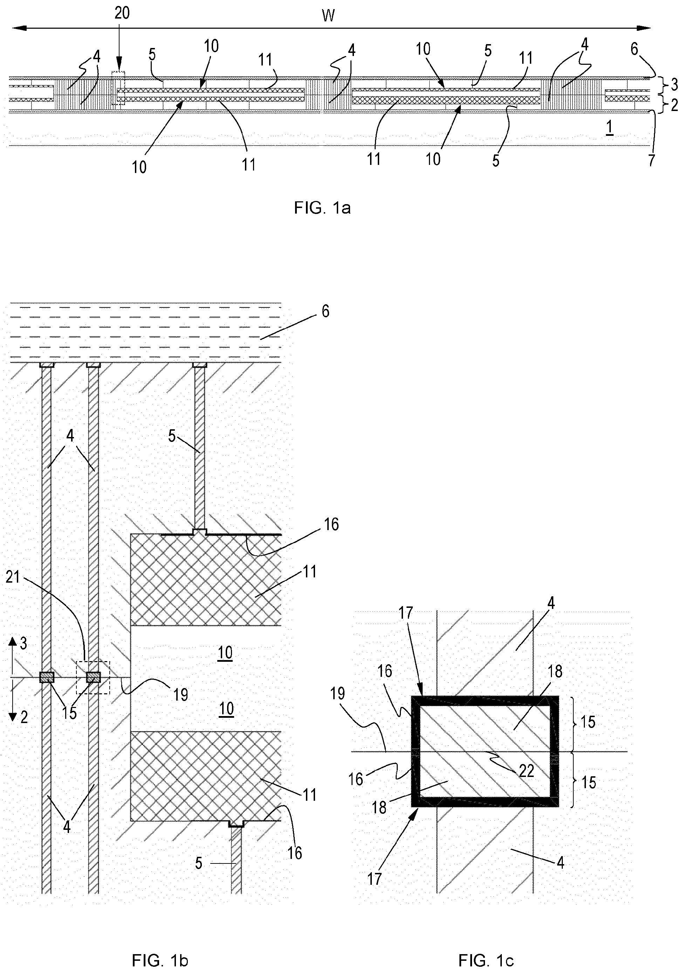

Figure 1a shows a small section of an assembly of micro-electronic components, two of which have been assembled in accordance with the invention. The assembly comprises a PCB board 1, an interposer 2 mounted on the PCB board, and a microchip 3 mounted on the interposer. The invention is relevant for the bonding of the chip 3 to the interposer 2. The image shows a section of width W of the stacked components, W being in the order of less than 1 mm, i.e. all three components extend for considerable lengths on either side of the illustrated section, the chip 3 being the smallest of the three. In the example shown, the microchip 3 and the interposer 2 are formed of silicon and are bonded together by direct silicon-on-silicon bonding of the bonding surfaces at the front sides of these two components. So called 'through substrate via' connections 4 and 5, hereafter abbreviated as TSV connections or TSVs, connect the front side of the chip 3 and of the interposer 2 to the back sides of these components. On the back side of the chip 3, a redistribution layer 6 is provided for interconnecting selected TSVs in the horizontal plane. The back side of the interposer 2 is bonded to a redistribution layer 7 on the front side of the PCB 1.

It is furthermore seen in Figure 1a that both the chip 3 and the interposer 2 are provided with cavities 10 which are open to the bonding surfaces. These cavities 10 have in-plane dimensions which are large in comparison with the diameter of the TSVs 4. Inside these large cavities 10, micro-electronic devices or parts thereof have been fabricated in accordance with the method of the invention, as will be described hereafter in more detail. The devices or parts thereof have been represented symbolically as hatched areas 11, but they can have multiple practical realisations and forms, not necessarily filling the full surface area of the cavities 10. The cavities 10 may for example comprise MEMS (micro-electromechanical system) devices or optical devices or parts thereof, or other micro-electronic devices or device portions known in the art. One particular application is the realization of a quantum processor wherein superconducting qubits or parts thereof are fabricated in the large cavities 10, leaving a specific desired gap between qubits or qubit parts fabricated in two mutually facing cavities 10 for the best qubit fidelity performance.

Still with reference to Figure 1a, it is seen that dense arrays of TSVs 4 are located in the areas between the large cavities 10. These densely packed TSVs 4 form connections between the front and back sides of the chip 3 and of the interposer 2. A smaller number of TSVs 5 connect the bottom area of the large cavities 10 to the back side of the chip 3 and the interposer 2. On the basis of the enlarged images shown in Figures 1b and 1c, these different TSVs and their interconnection will now be described in more detail.

In the enlarged view of the rectangle 20, illustrated in Figure 1b, and in the further enlargement of the interconnection 21 shown in Figure 1c, it is seen that the densely packed TSVs 4 of the chip 3 and the interposer 2 are in physical and electrical contact with contact pads 15 on the respective bonding sides of these two substrates (chip and interposer). Each of these contact pads 15 comprises a thin electrically conductive layer 16 on the bottom and sidewalls of small cavities 17, and an electrically conductive volume 18 that further fills the cavities 17. The contact pads 15 may have a circular cross-section having a diameter in the order of few micrometre down to submicron (i.e. <1 µm, for example about 0.5µm), while the TSVs 4 may also have a circular cross-section whose diameter is preferably smaller than the contact pad diameter. The TSV diametermay therefore also bein the order of few µm or smaller. The contact pads 15 and/or the TSVs 4 could also have a non-circular cross-section, for example an elongate rectangle-like cross-section, as will be described further in this text.

The large cavities 10 may have in-plane dimensions (for example the length of one side in the case of a square cavity or the diagonal in the case of a rectangular shape) in the order of tens or hundreds of micrometres depending on the application. The depth of these large cavities 10 is essentially constant across the surface area of the cavities and, again depending on the application, the value of this depth may vary within a broad range, between a few hundred nanometres, being equal to or in the same order of magnitude as the depth of the small cavities 17, up to tens of micrometres. The latter (i.e. deeper) cavities 10 are required for specific larger devices or device parts, such as MEMS or optical devices. In the example shown, the depth of the large cavities 10 is about 10 µm and these cavities may have a square shape with a side dimension in the order of about 100 µm, which are dimensions suitable for an application in the field of superconducting quantum computing (hereafter abbreviated as superconducting QC).

The volumes 18 may consist of a low resistive metal such as a solder or copper or any superconducting (hereafter abbreviated as SC) metals (Al, TiN, Nb,...) for QC applications. Matching 2-dimensional arrays of contact pads 15 are provided on the chip 3 and on the interposer 2 and these matching arrays are brought into mutual contact to form an electrical connection through the bonding process, which is in fact a hybrid bonding process, i.e. a combination of direct Si-to-Si bonding and metal to metal bonding, to thereby form the Si-Si interface 19 between the two substrates and multiple metal-to-metal electrical interconnects 21. The dividing line 22 between the volumes 18 may not be physically present, depending on the material used for these volumes. When the material is a solder for example, the two volumes will melt and eventually form a continuous volume of solder or intermetallic material.

The thin conductive layer 16 is also seen on a portion of the bottom area of the large cavities 10 in Figure 1b. The use of the same reference numeral 16 illustrates the fact that the layer 16 on the bottom of the large cavities 10 originates from the same deposition as the layers 16 which are lining the small cavities 17, and that (in the case illustrated) this layer 16 is patterned inside the area of the large cavity 10, in accordance with the design requirements of whichever device or device part 11 that is to be fabricated in said cavity 10. These features of the invention will now be described in more detail.

The method for producing an assembly of two components like the illustrated chip 3 and interposer 2, will now be described, in accordance with an embodiment of the invention, for the case of a direct silicon-to-silicon bond, which is for example suitable for the application of the invention in the field of superconducting QC. The method comprises the bonding step as well as a number of method steps applied prior to bonding. These preparatory method steps are applied at wafer level, i.e. on a larger process wafer that is to be divided into smaller chips and/or interposers at a later stage. The bonding step may be applied at wafer level or at die-level, i.e. it may be a wafer-to-wafer bonding step, a die-to-wafer bonding step or a die-to-die bonding step, depending on the application.

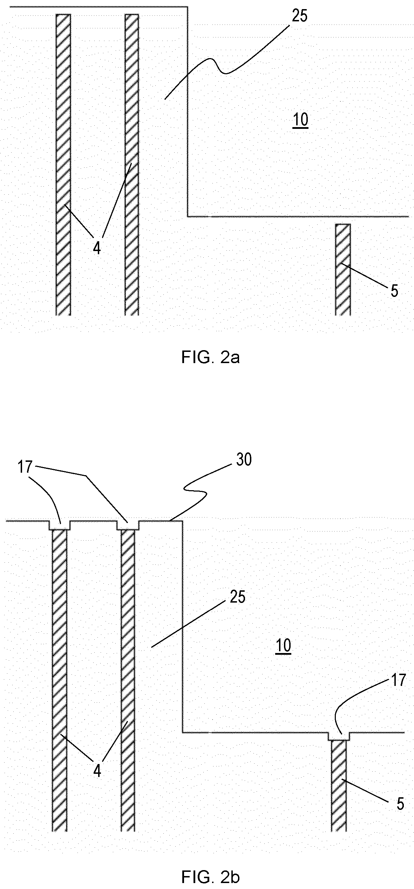

Figure 2a shows a detail of the interposer substrate 25, i.e. the substrate form which the actual interposer 2 will be obtained by dicing the substrate into smaller portions. This substrate 25 may be a silicon wafer onto which multiple interposers are to be processed. The substrate 25 is provided with the TSVs 4,5 and with a large cavity 10 as referred to above, i.e. the TSVs 4 are part of a dense array of TSVs passing through to the opposite side of the substrate 25, while TSVs 5 are located under the cavity 10. In the specific case shown, the TSVs 4 and 5 terminate at a short distance of for example 100 nm from the upper surface of the substrate and from the bottom surface of the cavity 10 respectively. This is specific to the case of Si-to-Si bonding and it is not a limitation of the invention. The way in which the substrate 25 including the TSVs 4,5 as shown in Figure 2a may be obtained will however be described first, as it is relevant also to other embodiments.

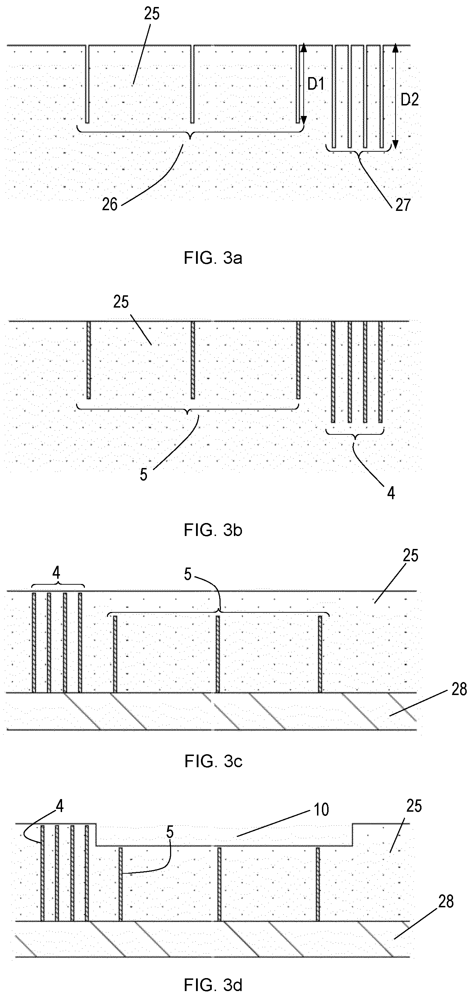

Reference is therefore first made to Figures 3a to 3c. A standard monocrystalline silicon process wafer 25 is used as the starting point. Such a wafer may have a thickness of several hundreds of micrometres and a diameter of 200mm or 300mm or others. A first and second set of TSV openings 26 and 27 are produced by two consecutive lithography and etch sequences. The openings may have a diameter in the order of 300-400 nm for example, and are etched down to two different depths D1 and D2, with a difference of about 10 µm. The depth of the openings from the surface of the wafer may be in the order of a hundred micron, so for example D1 may be about 100µm and D2 may be about 110µm. Litho/etch processes for producing such openings in silicon are well-known and need not be described here in detail. These openings 26 and 27 are subsequently filled with an electrically conductive material, for example copper or any SC metal (for QC applications) as illustrated in Figure 3b, possibly after first lining the sidewalls of the openings with a dielectric liner and after the formation of a seed layer and possibly a barrier layer (not shown). Such layers as well as deposition techniques for filling the openings are also well known in the art.

The upper surface of the silicon wafer 25 is planarized to remove the electrically conductive material deposited thereon, and to expose the top faces of the TSVs 4 and 5, as illustrated in Figure 3b. With reference to Figure 3c, the wafer is then flipped and temporarily bonded to a carrier substrate 28 by a suitable bonding layer (not shown), and the wafer is thereafter thinned from the back side, by grinding and planarization techniques such as CMP (chemical mechanical polishing). Planarization is stopped before reaching the deepest set of TSVs 4, for example stopping when about 100nm of silicon is left above the end faces of the TSVs 4. Then, as illustrated in Figure 3d, the large cavity 10 is formed by lithography and etching, while covering the areas of the first set of TSVs 4 by a suitable mask (not shown). Etching of the large cavity 10 is stopped before exposing the TSVs 5 of the second set, also leaving for example about 100 nm of Si above the end faces of those TSVs 5. These process steps thus yield the structure as shown in Figure 2a. According to other embodiments illustrated later in this description, the thinning and etching steps are performed such that the TSVs 4 and 5 protrude slightly (for example by about 100nm) through the surface of the silicon wafer 25, which is then followed by the deposition of an oxide layer to embed the protruding ends of the TSVs therein. However for the fabrication of superconducting qubits, no oxide formation is allowed as this will have a detrimental effect on the coherence time of the qubits.

Returning then to Figure 2a and to the subsequent figure 2b, a plurality of small cavities 17 is formed in alignment with the positions of the TSVs 4 and 5, and exposing the TSVs 4 and 5 at the bottom of these small cavities 17. The small cavities are open to the bonding surface 30, i.e. the upper rim of the sidewalls of these cavities 17 is at the same level as said bonding surface 30. The term' 'small' refers to the in-plane dimensions of these cavities 17 which are small compared to the in-plane dimensions of the large cavities 10. As stated above, the small cavities 17 may be circular in shape, having a diameter of about 500 nm for example, whereas the larger cavities 10 may have in-plane dimensions of up to several hundreds of micrometres, depending on the application. The formation of the small cavities 17 can be done by known lithography and etch techniques. Small cavities 17 are also formed inside the larger cavity 10, in alignment with the location of the TSVs 5. The initial large cavity 10 including the small cavities 17 at the bottom thereof is to be regarded as a single 'second cavity', in the wording of appended claim 1. The substrate onto which the microchip 3 is to be processed is prepared in the same way, i.e. having an array of small cavities 17 open to the bonding surface and a number of larger cavities 10. For preparing the specific assembly shown in Figures 1a and 1b, the following steps are applied to both the interposer substrate and the chip substrate.

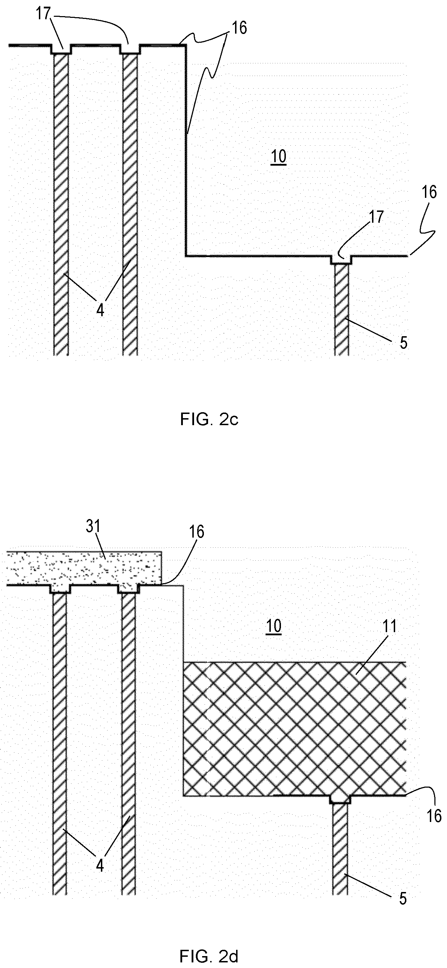

With reference to Figure 2c, a thin electrically conductive layer 16 is deposited conformally, i.e. following the topography of the small and large cavities 17 and 10. This layer 16 is thin, for example a few nanometres thick. When the method is applied in the field of superconducting QC, this layer 16 may be any metal having superconducting characteristics, such as Al, Ta, TaN, Ti, TiN, TiW, Ru, Zr, ZrN, Mo, In, Nb, NbTi, NbN, NbTiN, Nb₃Al or others. The layer 16 may be applied by PVD (physical vapour deposition) or ALD (atomic layer deposition) or CVD (chemical vapor deposition) or any other methods.

Following this and with reference to Figure 2d, a mask layer 31 is applied and patterned by standard lithography. This may be a photoresist layer for example. The patterning is such that the mask layer 31 covers the array of small cavities 17, while exposing the larger cavities 10. In said larger cavities 10, a number of processing steps are then performed, the result of which is also shown in Figure 2d, starting with the patterning of the thin conductive layer 16. In the case shown, this layer is removed from the sidewalls of the large cavity 10 and on the bottom of this large cavity, the layer is patterned in accordance with a given device layout. Then the device itself, or a part thereof, either one symbolized by the hatched area 11, is produced in the cavity 10, in accordance with any known production process for the device in question. For example in the case of superconducting QC, a qubit or a portion thereof may be processed in one of the large cavities 10 of the chip substrate. One known superconducting qubit design includes a pair of Josephson junctions coupled to a capacitor and a resonator. The Josephson junctions and one plate of the capacitor may for example be formed in a large cavity 10 of the chip substrate, while the other plate of the capacitor is formed in a matching large cavity of the interposer substrate.

In any application of the invention, the devices or parts thereof which are formed in the large cavities 10 do not extend above the bonding surface 30 of the substrate wherein such large cavities 10 are formed.

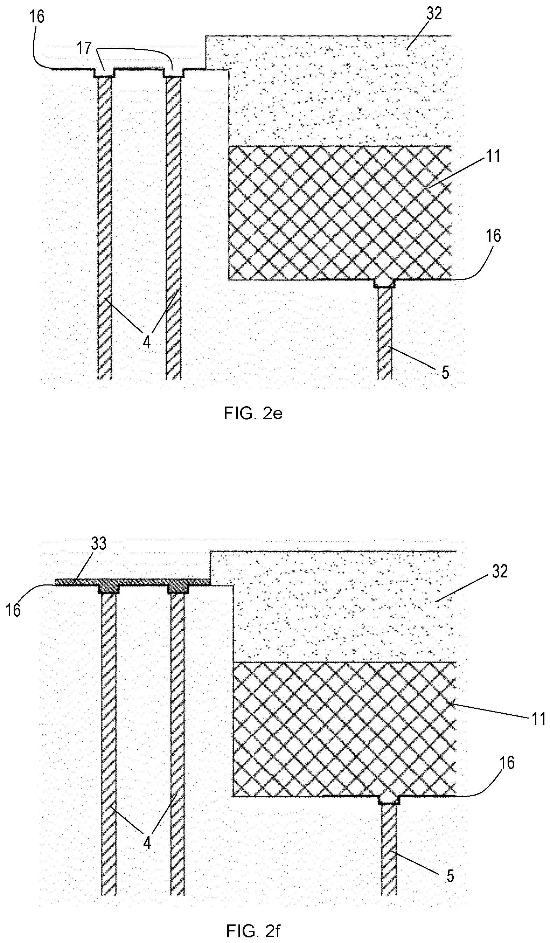

Referring now to Figure 2e, the next steps according to the particular embodiment illustrated in the drawings include the removal of the mask layer 31, and the formation of a second mask layer 32, now covering the device or device part 11 that has been fabricated in the large cavity 10, while exposing the array of small cavities 17.

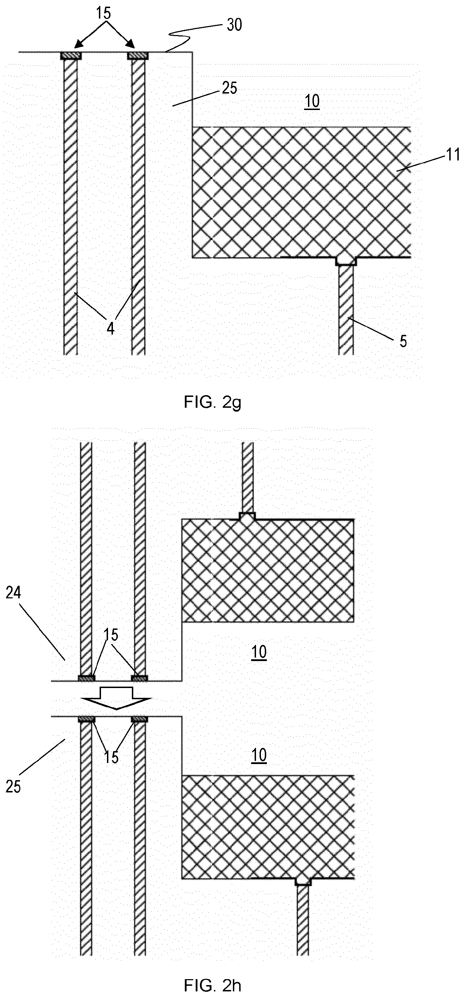

A metal layer 33 is then deposited, for example by electrodeposition, using the thin layer 16 as a seed layer, so that the metal is formed only on the exposed areas, as illustrated in Figure 2f. In the case of superconducting QC, layer 33 may be a solder material, for example a layer of indium. Thereafter, the second mask 32 is stripped and the substrate is subjected to a planarization step, removing the metal 33 as well as the thin conductive layer 16 from the bonding surface 30, as shown in Figure 2g, thereby creating an array of bonding pads 15 which are coplanar with the bonding surface 30.

This ends the preparation of the hybrid bonding step, which step is then performed by aligning the corresponding pads 15 and bringing the substrates 24 and 25 into mutual contact as illustrated in Figure 2h, possibly under increased pressure and temperature. Details of the bonding process as such are known for various types of bonding surfaces and metals and need not be described here. The result is the assembly as illustrated in Figures 1a and 1b. As stated, bonding may be performed wafer to wafer or die to wafer or die to die. In the particular case shown in Figure 1a/1b, the interposer substrate may first be diced to form individual interposers and one interposer 2 is then bonded to the PCB 1. Then the chip substrate is diced to form individual chips, and one or more chips 3 are bonded to the interposer 2. In another scenario, wafer to wafer bonding (such as substrate 24 to substrate 25) is applied and the obtained stack is diced to form packages of two bonded chips each, which may then be bonded to an interposer or a PCB. The invention is not limited to these examples and includes any number of combinations, as will be clear to the skilled person.

The devices or device parts 11 produced in the large cavities 10 may be connected to other parts of the assembly through the TSVs 5 and the redistribution layer 6 on the back side of the chip, and/or the redistribution layer 7 on the PCB 1.

The fabrication of the devices or device parts 11 in the cavities 10 provides an improved control of a number of device properties compared to presently known assembly techniques. For example in the case of superconducting qubits, the distance between facing capacitor plates can be controlled more accurately by producing said plates in mutually facing large cavities 10, given that the depth of these cavities can be controlled.

Having said this, and as already stated above, the invention is not limited to QC devices, but encompasses the fabrication of other devices such as MEMS or optical devices in the large cavities 10. For example a laser may be produced in one cavity 10, and a MEMS micromirror in the opposing cavity 10. Once again, the distance between these cooperating elements can be much better controlled using the approach of the invention.

An advantage that is common to all applications of the invention is the fact that the hybrid bonding approach enables a higher density of the contact pads 15 compared to a microbump interconnect approach.

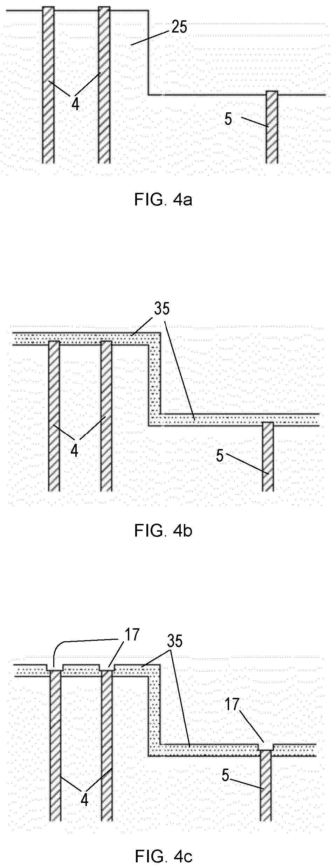

Contrary to QC devices, the fabrication of MEMS or optical devices does allow the use of dielectric bonding layers such as oxide layers as well as the use of dielectrics in the large cavities 10. This approach is illustrated in Figures 4a to 4c. It is seen that the TSVs 4 and 5 now protrude through the surface of the substrate 25 and that an oxide layer 35, for example formed of SiO₂, is formed on the upper surface of the substrate 25 and on the bottom of the large cavity 10. The small cavities 17 are formed in said oxide layer 35. After this, the steps are the same as described above. The oxide layer 35 serves as the bonding layer in a dielectric-to-dielectric (for example SiO₂ to SiO₂) direct hybrid bonding process known as such in the art, by which an assembly similar to the one shown in Figures 1a and 1b may be obtained.

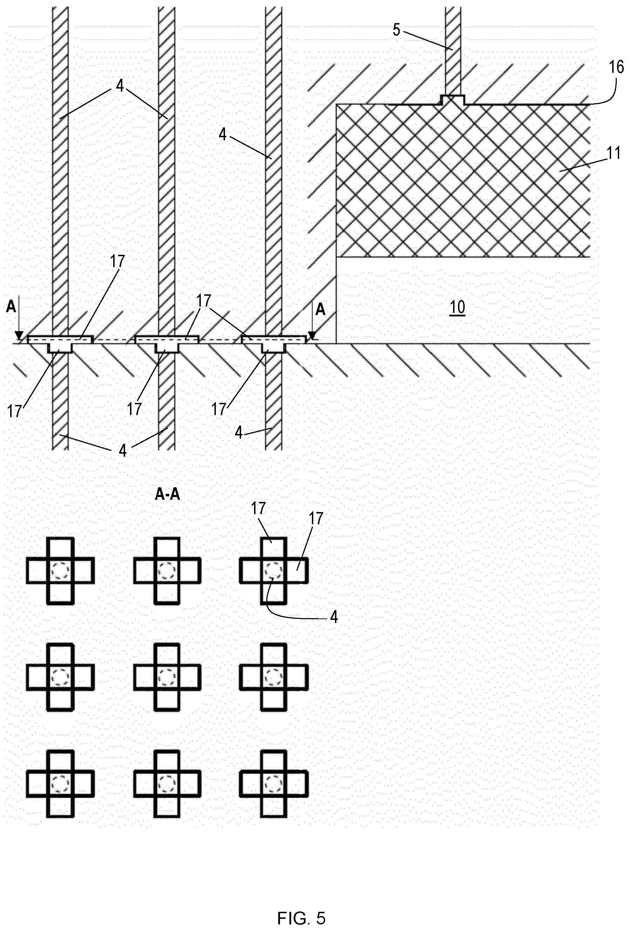

Figure 5 illustrates a number of possible alternatives for some of the features described so far. The alternatives are shown in the same image, but they can be applied independently from each other. The first alternative regards the shape and relative orientation of the small cavities 17. As seen in Figure 5, these small cavities 17 may have elongate shapes, represented as rectangles in the image, with the cavities 17 of the two substrates overlapping each other at essentially right angles. The shapes may be rounded at the narrow ends. A second alternative is related to the filling of the small cavities 17. According to embodiments, it is possible to skip the steps illustrated in Figures 2e and 2f, i.e. the small cavities 17 are not filled with the metal 33, and the CMP step removes only the thin layer 16 from the bonding surface 30. This thin layer 16 alone then establishes the electrical connection between the bonded substrates. This embodiment can be applied in cases where the devices or device parts produced in the large cavities 10 are incompatible with a number of contact metals or solder materials. Although these features (long cavities and no solder/metal fill) can be applied independently from each other, their combination is especially useful as the overlapping elongate shapes ensure that an electrical connection between the cavities 17 can be established also in the case of a limited misalignment. A third alternative illustrated in Figure 5 is the fact that the lower substrate does not comprise a large cavity facing the large cavity 10 on the upper substrate. In fact, the invention is not limited to the case where both bonded substrates include both large and small cavities. It is sufficient that both substrates include small cavities 17 and at least one substrate includes one or more large cavities 10.

In the embodiment of Figure 5, the cross-section of the TSVs 4 and 5 need not be circular in shape, but could also be rectangular.

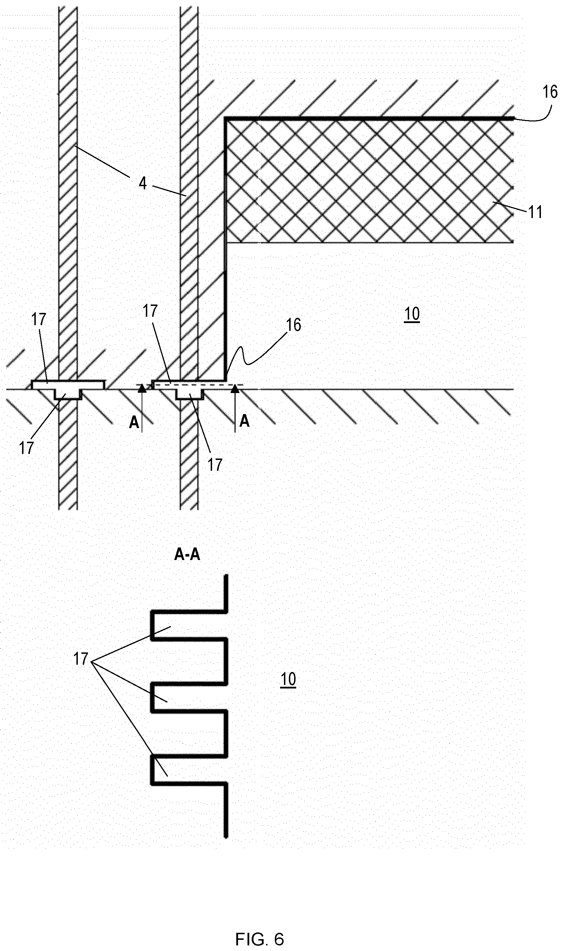

According to an embodiment, the thin conductive layer 16 is used to realize an electrical connection between a number of the small cavities 17 and a large cavity 10 directly bordering these small cavities 17 on the same substrate. Such an embodiment is illustrated in Figure 6. It is seen that the thin conductive layer 16 has now been maintained on the sidewall of the large cavity 10, and that a number of small cavities 17 are directly bordering the large cavity, so that the large cavity 10 and these directly bordering small cavities 17 form one common cavity. In a top view, as illustrated in Figure 6, it can be said that the small cavities 17 are branching out from the large cavity 10. The thin conductive layer 16 is seen to connect the device 11 inside the large cavity 10 to the small cavities 17 branching out from the larger one. This is therefore an alternative way of contacting the device 11.

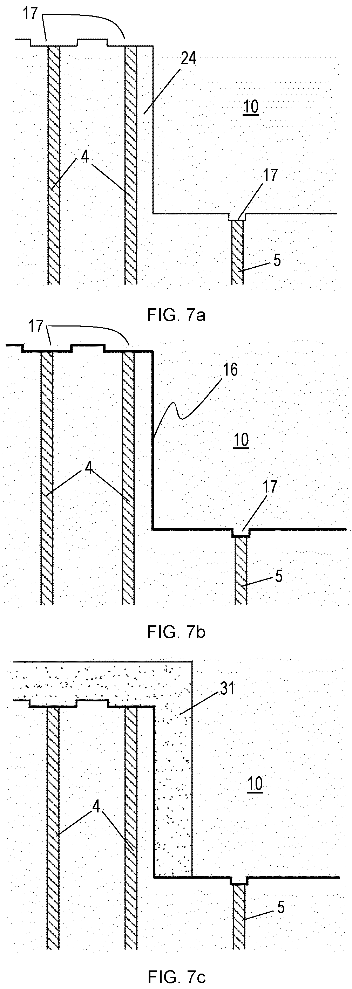

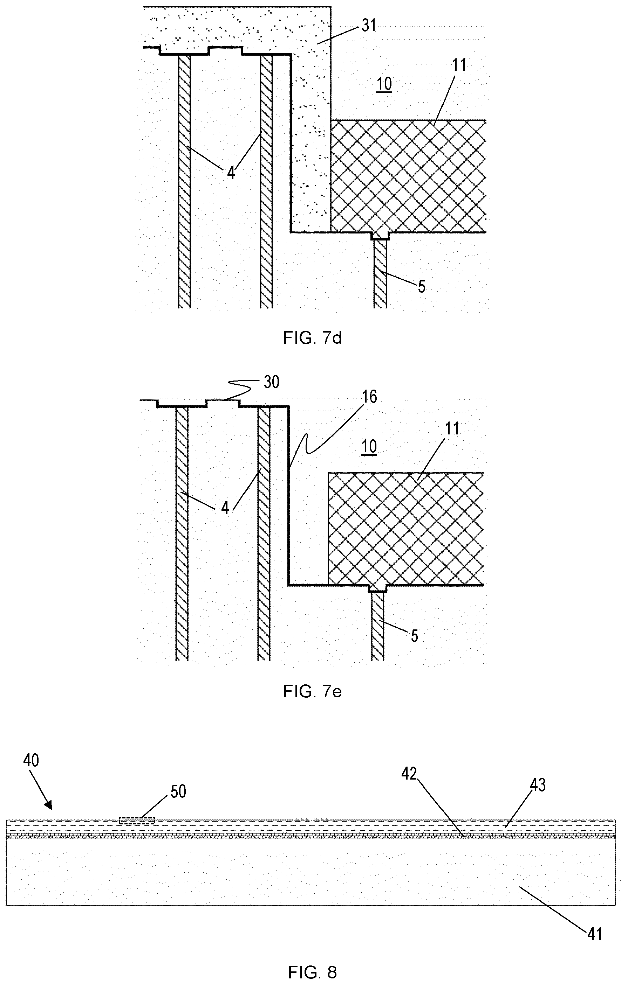

Figure 7a shows the upper substrate 24 of the assembly shown in Figure 6 before the deposition of the thin conductive layer 16. The application of said layer 16 is illustrated in Figure 7b. A patterned mask layer 31 is produced which now covers the sidewall of the large cavity 10 (Fig. 7c). The device 11 is processed in the large cavity 10 (Fig. 7d). Then the mask layer 31 is stripped and the bonding surface 30 is planarized, removing the thin layer 16 from said bonding surface (Fig. 7e). After this, the substrate is bonded to the lower substrate, leading to the result shown in Figure 6.

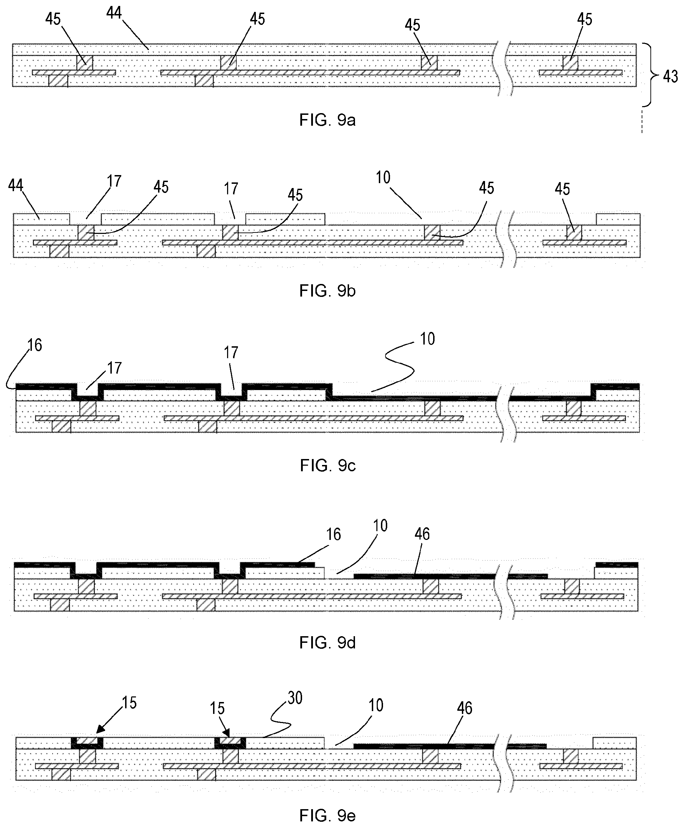

In the above-described embodiments, the large cavities 10 have depths which are significantly higher than the depth of the small cavities 17. This is required for producing certain types of complete devices or major portions thereof in the large cavities 10. The invention however also includes embodiments wherein the large cavities 10 have essentially the same depth as the small cavities 17. An embodiment of this type is illustrated in Figure 8, and Figures 9a-9e. Figure 8 represents one substrate 40 that is to be bonded to another substrate by a method in accordance with the invention. The substrate 40 may be an integrated circuit chip that is either still part of a larger process wafer or that has been separated therefrom by dicing. The chip 40 comprises a number of portions which are well-known to persons skilled in the art : a silicon substrate 41, a front end of line portion 42 comprising active devices, a back end of line portion 43 comprising multiple interconnect levels. The detail section 50 is shown at an enlarged scale in Figure 9a. It is seen that the BEOL portion 43 is not fully completed: a dielectric layer 44, for example SiO₂, covers the via connections 45 of the top interconnect level. With reference to Figure 9b, the small cavities 17 are then produced by lithography and etching, as well as a large cavity 10 having the same depth as the small cavities 17, but having much larger in-plane dimensions, which may be up to a few hundreds of microns, depending on the application. For example, the large cavity 10 could be aimed at containing one plate of a capacitor of a superconducting qubit. The small cavities 17 are aligned to the interconnect vias 45, so that these vias become available for contacting at the bottom of the small cavities 17. Likewise, other interconnect vias 45 become available for contacting at the bottom of the large cavities 10.

As shown in Figure 9c, the thin conductive layer 16 is formed, as in the previous embodiments, conformally covering the surfaces of both the small and large cavities 17 and 10. Then a mask layer is applied (not shown), and the conductive layer 16 is patterned inside the large cavity 10, for example for forming said capacitor plate 46 (Fig. 9d). Finally, the small cavities 17 may be filled with a contact metal, after which the substrate is subjected to CMP to arrive at the result shown in Figure 9e, including the contact pads 15 coplanar with the bonding surface 30. This substrate can then be bonded to another substrate provided with a large and possibly a deep cavity, for example comprising the other plate of the capacitor as well as other parts of the superconducting qubit.

Many practical embodiments of the invention require the presence of conductors embedded in the substrates that are to be bonded, and which become available for contacting at the bottom of the small or large cavities 17/10. Examples of such conductors are the TSVs 4 and 5 in the embodiments of Figures 1, 5 and 6, or the interconnect vias 45 in the embodiment of Figures 9a-9e. It is however not excluded that one substrate comprises only small cavities 17 branching out from a large cavity 10, as in the embodiment of Figure 6. Said small cavities 17 do not require a connection to TSVs or other conductors directly to the bottom of these cavities. These cavities can be connected to matching cavities in the opposite substrate which are coupled to TSVs or other conductors, thereby enabling to contact a device in the large cavity 10.

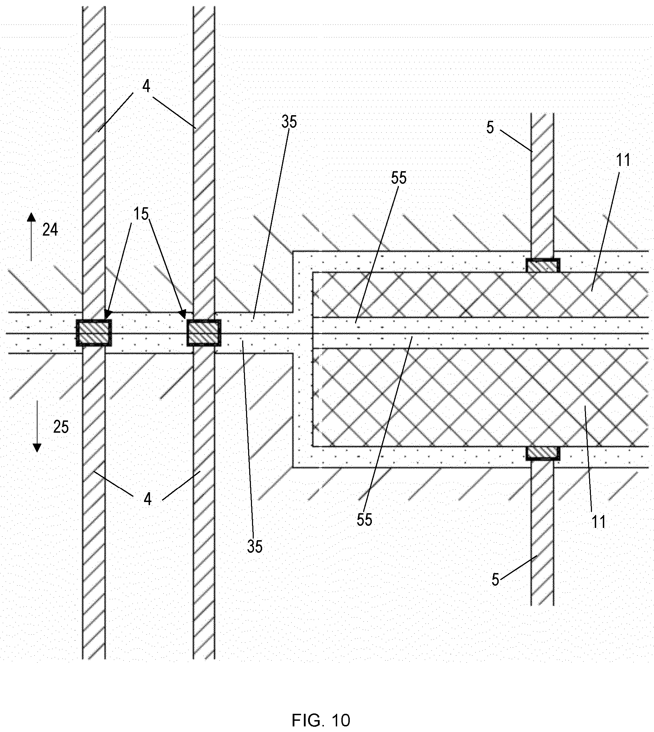

It is not required that an air gap remains above the device 11, as shown in the previous drawings. Certain types of device may be fully embedded in an oxide for example, as illustrated in Figure 10, where an oxide layer 55 is formed on top of the device 11 and wherein said layer 55 is coplanar with the oxide bonding layers 35 (as shown in Figures 4a-4c) of the substrates 24 and 25, after the planarization step immediately preceding the bonding step. The surface of said oxide layer 55 thereby becomes an additional part of the bonding surfaces which form the interface between the substrates in the final assembly.

The invention is related also to an assembly of micro-electronic components obtainable by the method of the invention. Such an assembly comprises at least two stacked components, for example the chip 3 and the interposer 2 illustrated in Figures 1a-1c. The components are bonded along a bonding interface 19, and comprise matching pluralities of interconnected first cavities 17. In the assembly, the cavities can be said to be 'open to the bonding interface 19'. The first cavities 17 of the two components are interconnected at least by layers 16 of a first electrically conductive material lining the sidewalls and bottom of said first cavities 17. At least one component further comprises a second cavity 10 open to the bonding interface 19 that has in-plane dimensions which are larger than the in-plane dimensions of the first cavities 17. The second cavity 10 comprises a micro-electronic device or a part thereof that is electrically connected, through a layer 16 of the first conductive material present at least on the bottom area of the second cavity 10, to one or more other components of the stacked assembly.

Additional embodiments and alternative forms of the assembly according to the invention include various features and alternatives described in relation to the method of the invention, such as the presence of the second conductive material 33, the elongate shape and crosswise arrangement of the first cavities 17, first cavities 17 branching out from a second cavity 10, etc.

## Claims

1. A method for producing a stacked assembly of micro-electronic components, the method comprising the steps of:
- providing a first and second substrate (24,25), each substrate having a planar bonding surface (30), wherein :
∘ the first substrate and the second substrate both comprise a group of first cavities (17) open to the respective bonding surfaces,
∘ the groups of first cavities (17) are arranged in mutually matching patterns on the first and second substrate,
∘ at least one of the substrates comprises at least one second cavity (10) open to the bonding surface (30) of said substrate, wherein the second cavity has larger in-plane dimensions than the in-plane dimensions of the first cavities,
∘at least one of the substrates comprises electrical conductors (4,5,45) embedded in the substrate and available for contacting electrical conductors at a bottom portion of the first cavities (17) and/or the second cavity (10),
- producing a first and second layer (16) formed of a first electrically conductive material on said respective bonding surfaces (30), said layers conformally covering said bonding surfaces and the sidewalls and bottom surfaces of the first cavities (17) and of the second cavity (10),
- patterning the layer (16) formed of the first conductive material in the second cavity (10) and producing a micro-electronic device or a part thereof in said second cavity (10), wherein said device or part does not extend above the bonding surface (30) of the substrate comprising the second cavity (10),
- by a planarization technique, removing the layers (16) formed of the first electrically conductive material from the bonding surfaces (30) while keeping said layers at least on the bottom and sidewalls of the first cavities (17),
- bonding and interconnecting the substrates (24,25), to thereby obtain said stacked assembly of components, wherein at least the sidewalls of the first cavities (17) of the first substrate overlap corresponding sidewalls of the first cavities (17) of the second substrate so that an electrical connection is established between said respective sidewalls, and wherein the device or device part in the second cavity (10) is electrically connected to one or more other components of the stack.

2. The method according to claim 1, further comprising the following steps applied to the two substrates (24,25) :
- prior to applying said planarization technique, depositing a second electrically conductive material (33) in the first cavities (17) and on the bonding surface (30) in between said first cavities,
- by applying said planarization technique, removing both the second and first conductive materials from the bonding surface (30), before performing the bonding step.

3. The method according to any one of the preceding claims, wherein on at least one of the substrates (24,25), said second cavity (10) and a plurality of the first cavities (17) are together forming a common cavity, said plurality of the first cavities (17) branching out from one or more sidewalls of the second cavity (10), and wherein the layer (16) of the first conductive material is maintained on said one or more sidewalls of the second cavity (10) so that said layer (16) forms an electrical connection between said plurality of the first cavities (17) and the second cavity (10).

4. The method according to any one of the preceding claims, wherein the electrical connection between the matching first cavities (17) of the two substrates (24,25) is established only by the layers (16) of the first conductive material on the sidewalls and the bottom of said first cavities (17).

5. The method according to any one of the preceding claims, wherein the first cavities (17) have an elongate shape, and wherein the first cavities (17) of the first substrate (24) overlap the first cavities (17) of the second substrate (25) in a crosswise fashion.

6. The method according to any one of the preceding claims, wherein at least some of said number of conductors are through substrate via (TSV) connections (4,5).

7. The method according to any one of the preceding claims, wherein at least some of said number of conductors are interconnect vias (45) which are part of a back end of line type interconnect structure (43).

8. The method according to any one of the preceding claims, wherein the depth of the second cavity (10) is considerably larger than the depth of the first cavities (17).

9. The method according to any one of the preceding claims, wherein the depth of the second cavity (10) is the same as the depth of the first cavities (17).

10. The method according to any one of the preceding claims, wherein said devices or parts thereof (11) are superconducting qubits or parts thereof.

11. The method according to claim 10, wherein the first substrate comprises a number of said second cavities (10), each of said number comprising multiple elements of a superconducting qubit including one plate of a capacitor, and wherein the second substrate comprises an equal number of said second cavities (10), each comprising another capacitor plate that is capacitively coupled to the plates in the first substrate after the bonding step.

12. A stacked assembly of micro-electronic components, at least two of said components (2,3) being bonded along a bonding interface (19), and comprising matching pluralities of interconnected first cavities open to the bonding interface (19), wherein said first cavities of the two components are interconnected at least by layers (16) of a first electrically conductive material lining the sidewalls and bottom of said first cavities (17), and wherein at least one component further comprises a second cavity (10) open to the bonding interface (19) that has in-plane dimensions which are larger than the in-plane dimensions of the first cavities (17), and wherein said second cavity comprises a micro-electronic device or a part thereof,
**characterised in that** the micro-electronic device or part thereof
is electrically connected through a layer (16) of the first conductive material present at least on a bottom area of the second cavity (10), to one or more other components of the stacked assembly.

13. The assembly according to claim 12, wherein said devices or parts thereof are superconducting qubits or parts thereof.

## Patentansprüche

1. Verfahren zur Herstellung einer gestapelten Anordnung mikroelektronischer Bauteile, wobei das Verfahren die folgenden Schritte umfasst:
- Bereitstellen eines ersten und zweiten Substrats (24,25), wobei jedes Substrat eine planare Verbindungsfläche (30) aufweist, wobei:
- das erste Substrat und das zweite Substrat jeweils eine Gruppe von ersten Hohlräumen (17) umfassen, die zu den jeweiligen Verbindungsflächen hin offen sind,
- die Gruppen erster Hohlräume (17) auf dem ersten und zweiten Substrat in zueinander übereinstimmenden Mustern angeordnet sind,
- mindestens eines der Substrate mindestens einen zweiten Hohlraum (10) umfasst, der zur Verbindungsfläche (30) des Substrats hin offen ist, wobei der zweite Hohlraum größere planare Abmessungen aufweist als die planaren Abmessungen der ersten Hohlräume,
- mindestens eines der Substrate elektrische Leiter (4,5,45) umfasst, die in das Substrat eingebettet sind und zur Kontaktaufnahme mit elektrischen Leitern an einem unteren Abschnitt der ersten Hohlräume (17) und oder des zweiten Hohlraums (10) zur Verfügung stehen,
- Herstellen einer ersten und zweiten Schicht (16) aus einem ersten elektrisch leitfähigen Material auf den jeweiligen Verbindungsflächen (30), wobei die Schichten die Verbindungsflächen sowie die Seitenwände und Bodenflächen der ersten Hohlräume (17) und des zweiten Hohlraums (10) konform bedecken,
- Strukturieren der aus dem ersten leitfähigen Material gebildeten Schicht (16) in dem zweiten Hohlraum (10) und Herstellen einer mikroelektronischen Vorrichtung oder eines Teils davon in dem zweiten Hohlraum (10), wobei sich die Vorrichtung oder der Teil nicht über die Verbindungsfläche (30) des Substrats, das den zweiten Hohlraum (10) umfasst, hinaus erstreckt,
- Entfernen, durch eine Planarisierungstechnik, der aus dem ersten elektrisch leitfähigen Material gebildeten Schichten (16) von den Verbindungsflächen (30), während diese Schichten mindestens am Boden und an den Seitenwänden der ersten Hohlräume (17) aufrechterhalten werden,
- Verbinden und Miteinanderverbinden der Substrate (24, 25), um die gestapelte Anordnung von Bauteilen zu erhalten, wobei mindestens die Seitenwände der ersten Hohlräume (17) des ersten Substrats entsprechende Seitenwände der ersten Hohlräume (17) des zweiten Substrats überlappen, sodass eine elektrische Verbindung zwischen den jeweiligen Seitenwänden hergestellt wird, und wobei die Vorrichtung oder der Vorrichtungsteil in dem zweiten Hohlraum (10) elektrisch mit einer oder mehreren anderen Bauteilen des Stapels verbunden ist.

2. Verfahren nach Anspruch 1, ferner umfassend die folgenden Schritte, die auf die beiden Substrate (24, 25) angewendet werden:
- Abscheiden, vor Anwendung der genannten Planarisierungstechnik, eines zweiten elektrisch leitfähigen Materials (33) in den ersten Hohlräumen (17) und auf der Verbindungsfläche (30) zwischen den ersten Hohlräumen,
- Entfernen, durch Anwendung der genannten Planarisierungstechnik, sowohl des zweiten als auch des ersten leitfähigen Materials von der Verbindungsfläche (30), bevor der Verbindungsschritt durchgeführt wird.

3. Verfahren nach einem der vorstehenden Ansprüche, wobei auf mindestens einem der Substrate (24, 25) der zweite Hohlraum (10) und eine Vielzahl der ersten Hohlräume (17) zusammen einen gemeinsamen Hohlraum bilden, wobei sich die Vielzahl erster Hohlräume (17) von einer oder mehreren Seitenwänden des zweiten Hohlraums (10) abzweigen und wobei die Schicht (16) des ersten leitfähigen Materials auf der einen oder den mehreren Seitenwänden des zweiten Hohlraums (10) so aufrechterhalten wird, sodass die Schicht (16) eine elektrische Verbindung zwischen der Vielzahl von ersten Hohlräumen (17) und dem zweiten Hohlraum (10) herstellt.

4. Verfahren nach einem der vorstehenden Ansprüche, wobei die elektrische Verbindung zwischen den übereinstimmenden ersten Hohlräumen (17) der beiden Substrate (24, 25) nur durch die Schichten (16) des ersten leitfähigen Materials an den Seitenwänden und am Boden der ersten Hohlräume (17) hergestellt wird.

5. Verfahren nach einem der vorstehenden Ansprüche, wobei die ersten Hohlräume (17) eine längliche Form aufweisen und wobei die ersten Hohlräume (17) des ersten Substrats (24) die ersten Hohlräume (17) des zweiten Substrats (25) kreuzweise überlappen.

6. Verfahren nach einem der vorstehenden Ansprüche, wobei mindestens einige der Anzahl von Leitern durch Substrat-Durchkontaktierung-Verbindungen (TSV-Verbindungen) (4,5) geführt sind.

7. Verfahren nach einem der vorstehenden Ansprüche, wobei mindestens einige der Anzahl von Leitern Verbindungsdurchkontaktierungen (45) sind, die Teil eines Rückendes einer linienförmigen Verbindungsstruktur (43) sind.

8. Verfahren nach einem der vorstehenden Ansprüche, wobei die Tiefe des zweiten Hohlraums (10) wesentlich größer ist als die Tiefe der ersten Hohlräume (17).

9. Verfahren nach einem der vorstehenden Ansprüche, wobei die Tiefe des zweiten Hohlraums (10) gleich der Tiefe der ersten Hohlräume (17) ist.

10. Verfahren nach einem der vorstehenden Ansprüche, wobei es sich bei den Vorrichtungen oder Teilen davon (11) um supraleitende Qubits oder Teile davon handelt.

11. Verfahren nach Anspruch 10, wobei das erste Substrat eine Anzahl der zweiten Hohlräumen (10) umfasst, von denen jeder der Anzahl mehrere Elemente eines supraleitenden Qubits umfasst, das eine Kondensatorplatte einschließt, und wobei das zweite Substrat eine gleiche Anzahl von zweiten Hohlräumen (10) umfasst, von denen jeder eine weitere Kondensatorplatte umfasst, die nach dem Verbindungsschritt kapazitiv mit den Platten im ersten Substrat gekoppelt ist.

12. Gestapelte Anordnung mikroelektronischer Bauteile, wobei mindestens zwei dieser Bauteile (2, 3) entlang einer Verbindungsgrenzfläche (19) verbunden sind und mehrere übereinstimmende, miteinander verbundene erste Hohlräume umfassen, die zur Verbindungsgrenzfläche (19) hin offen sind, wobei die ersten Hohlräume der beiden Bauteile mindestens durch Schichten (16) eines ersten elektrisch leitfähigen Materials miteinander verbunden sind, das die Seitenwände und den Boden der ersten Hohlräume (17) auskleidet, und wobei mindestens ein Bauteil ferner einen zweiten Hohlraum (10) umfasst, der zur Verbindungsgrenzfläche (19) hin offen ist und dessen planare Abmessungen größer sind als die planaren Abmessungen der ersten Hohlräume (17), und wobei der zweite Hohlraum eine mikroelektronische Vorrichtung oder einen Teil davon umfasst, **dadurch gekennzeichnet, dass** die mikroelektronische Vorrichtung oder der Teil davon über eine Schicht (16) des ersten leitfähigen Materials, die sich mindestens auf einem Bodenbereich des zweiten Hohlraums (10) befindet, elektrisch mit einem oder mehreren anderen Bauteilen der gestapelten Anordnung verbunden ist.

13. Anordnung nach Anspruch 12, wobei es sich bei den Vorrichtungen oder Teilen davon um supraleitende Qubits oder Teile davon handelt.

## Revendications

1. Procédé de fabrication d'un assemblage empilé de composants microélectroniques, le procédé comprenant les étapes consistant à :
- fournir un premier et un deuxième substrat (24, 25), chaque substrat présentant une surface de liaison plane (30), dans lequel :
- le premier substrat et le deuxième substrat comprennent tous deux un groupe de premières cavités (17) ouvertes sur les surfaces de liaison respectives,
- les groupes de premières cavités (17) sont disposés selon des motifs mutuellement correspondants sur le premier et le deuxième substrat,
- au moins un des substrats comprend au moins une deuxième cavité (10) ouverte sur la surface de liaison (30) dudit substrat, dans lequel la deuxième cavité présente des dimensions dans le plan plus grandes que les dimensions dans le plan des premières cavités,
- au moins un des substrats comprend des conducteurs électriques (4, 5, 45) intégrés dans le substrat et disponibles pour entrer en contact avec des conducteurs électriques dans une partie inférieure des premières cavités (17) et/ou de la deuxième cavité (10),
- produire une première et une deuxième couche (16) formées d'un premier matériau électriquement conducteur sur lesdites surfaces de liaison respectives (30), lesdites couches recouvrant de manière conforme lesdites surfaces de liaison ainsi que les parois latérales et les surfaces inférieures des premières cavités (17) et de la deuxième cavité (10),
- structurer la couche (16) formée du premier matériau conducteur dans la deuxième cavité (10) et produire un dispositif microélectronique ou une partie de celui-ci dans ladite deuxième cavité (10), dans lequel ledit dispositif ou ladite partie ne s'étendent pas au-dessus de la surface de liaison (30) du substrat comprenant la deuxième cavité (10),
- par une technique de planarisation, supprimer les couches (16) formées du premier matériau électriquement conducteur des surfaces de liaison (30) tout en conservant ces couches au moins sur le fond et les parois latérales des premières cavités (17),
- lier et interconnecter les substrats (24,25), afin d'obtenir ainsi ledit assemblage empilé de composants, dans lequel au moins les parois latérales des premières cavités (17) du premier substrat chevauchent les parois latérales correspondantes des premières cavités (17) du deuxième substrat de sorte qu'une connexion électrique soit établie entre lesdites parois latérales respectives, et dans lequel le dispositif ou la partie de dispositif dans la deuxième cavité (10) est électriquement connecté(e) à un ou plusieurs autres composants de l'empilement.

2. Procédé selon la revendication 1, comprenant en outre les étapes suivantes appliquées aux deux substrats (24, 25) :
- avant d'appliquer ladite technique de planarisation, déposer un deuxième matériau électriquement conducteur (33) dans les premières cavités (17) et sur la surface de liaison (30) entre lesdites premières cavités,
- en appliquant ladite technique de planarisation, éliminer à la fois le deuxième et le premier matériau conducteur de la surface de liaison (30), avant d'effectuer l'étape de liaison.

3. Procédé selon l'une quelconque des revendications précédentes, dans lequel, sur au moins un des substrats (24, 25), ladite deuxième cavité (10) et une pluralité de premières cavités (17) forment ensemble une cavité commune, ladite pluralité de premières cavités (17) se ramifiant à partir d'une ou plusieurs parois latérales de la deuxième cavité (10), et dans lequel la couche (16) du premier matériau conducteur est maintenue sur lesdites parois latérales de la deuxième cavité (10) de sorte que ladite couche (16) forme une connexion électrique entre lesdites premières cavités (17) et la deuxième cavité (10).

4. Procédé selon l'une quelconque des revendications précédentes, dans lequel la connexion électrique entre les premières cavités correspondantes (17) des deux substrats (24, 25) est établie uniquement par les couches (16) du premier matériau conducteur sur les parois latérales et le fond desdites premières cavités (17).

5. Procédé selon l'une quelconque des revendications précédentes, dans lequel les premières cavités (17) présentent une forme allongée, et dans lequel les premières cavités (17) du premier substrat (24) chevauchent les premières cavités (17) du deuxième substrat (25) de manière transversale.

6. Procédé selon l'une quelconque des revendications précédentes, dans lequel au moins une partie dudit nombre de conducteurs est constituée de connexions traversant le substrat (TSV) (4, 5).

7. Procédé selon l'une quelconque des revendications précédentes, dans lequel au moins une partie dudit nombre de conducteurs sont des vias d'interconnexion (45) qui font partie d'une structure d'interconnexion de type ligne à l'arrière (43).

8. Procédé selon l'une quelconque des revendications précédentes, dans lequel la profondeur de la deuxième cavité (10) est considérablement plus grande que la profondeur des premières cavités (17).

9. Procédé selon l'une quelconque des revendications précédentes, dans lequel la profondeur de la deuxième cavité (10) est la même que la profondeur des premières cavités (17).

10. Procédé selon l'une quelconque des revendications précédentes, dans lequel lesdits dispositifs ou des parties de ceux-ci (11) sont des qubits supraconducteurs ou des parties de ceux-ci.

11. Procédé selon la revendication 10, dans lequel le premier substrat comprend un certain nombre desdites deuxièmes cavités (10), chacune de ces cavités comprenant plusieurs éléments d'un qubit supraconducteur incluant une plaque de condensateur, et dans lequel le deuxième substrat comprend un nombre égal desdites deuxièmes cavités (10), chacune comprenant une autre plaque de condensateur qui est couplée de manière capacitive aux plaques du premier substrat après l'étape de liaison.

12. Assemblage empilé de composants microélectroniques, au moins deux desdits composants (2, 3) sont liés le long d'une interface de liaison (19), et comprenant une pluralité correspondante de premières cavités interconnectées ouvertes sur l'interface de liaison (19), dans lequel lesdites premières cavités des deux composants sont interconnectées au moins par des couches (16) d'un premier matériau électriquement conducteur tapissant les parois latérales et le fond desdites premières cavités (17), et dans lequel au moins un composant comprend en outre une deuxième cavité (10) ouverte sur l'interface de liaison (19) dont les dimensions dans le plan sont supérieures à celles des premières cavités (17), et dans lequel ladite deuxième cavité comprend un dispositif microélectronique ou une partie de celui-ci, **caractérisé en ce que** le dispositif microélectronique ou la partie de celui-ci est connecté(e) électriquement, par l'intermédiaire d'une couche (16) du premier matériau conducteur présente au moins sur une zone inférieure de la deuxième cavité (10), à un ou plusieurs autres composants de l'assemblage empilé.

13. Assemblage selon la revendication 12, dans lequel lesdits dispositifs ou parties de ceux-ci sont des qubits supraconducteurs ou des parties de ceux-ci.
